Europäisches Patentamt

European Patent Office

Office européen des brevets

(19)

(11) **EP 1 580 886 A1**

(12) **EUROPEAN PATENT APPLICATION**
published in accordance with Art. 158(3) EPC

(43) Date of publication:
28.09.2005 Bulletin 2005/39

(51) Int Cl.7: **H03H 11/04**

(21) Application number: 03772801.1

(86) International application number:
**PCT/JP2003/014561**

(22) Date of filing: 17.11.2003

(87) International publication number:
**WO 2004/047291 (03.06.2004 Gazette 2004/23)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **19.11.2002 JP 2002335741**

(71) Applicant: **MATSUSHITA ELECTRIC INDUSTRIAL CO., LTD.**
**Kadoma-shi, Osaka 571-8501 (JP)**

(72) Inventors:
• NAKAMURA, Makoto
Kyoto-shi, Kyoto 615-8256 (JP)
• YONEDA, Takuji
Nishinomiya-shi, Hyogo 663-8187 (JP)
• KURIMOTO, Hidehiko
Takatsuki-shi, Osaka 569-0813 (JP)
• WATANABE, Takeaki
Otokuni-gun, Kyoto 618-0071 (JP)

(74) Representative: **Schorr, Frank Jürgen et al**
**Diehl Glaeser Hiltl & Partner,**
**Augustenstrasse 46**
**80333 München (DE)**

(54) **FILTER DEVICE**

(57) A filter device is provided that can easily achieve reduction in current consumption and whose variations can be corrected. A phase difference of a reference filter is detected by a phase difference detector, a control signal for correcting variations that is obtained as a result of the detection is held in a register, and a cut-off frequency of a main filter is selected according to the control signal thus held. Thus, once variations are detected, the reference filter and the phase difference detector that are used for detection of variations become no longer necessary and their operations can be halted, thereby achieving reduction in current consumption.

FIG. 1

**Description**

**TECHNICAL FIELD**

The present invention relates to a filter device for use particularly in a reception IQ demodulator circuit of a mobile phone, which is installed in a semiconductor apparatus and whose variations can be corrected.

BACKGROUND ART

In recent years, there has been a strong demand for a reduction in the size of mobile phones, and thus a configuration has become common in which a filter device is installed in a semiconductor apparatus. Meanwhile, in order to allow a call waiting state to be maintained for as long as possible, it has been requested that current consumption be reduced drastically particularly in parts constituting a reception circuit.

Before the conventional technique is discussed, a method of correcting variations of a filter device installed in a semiconductor apparatus will be described in the following.

Variations mentioned herein refer to variations in a so-called CR product, namely, a product of variations in absolute value that occur in a resistance and a capacitor, which constitute a filter device, uniquely to a semiconductor apparatus.

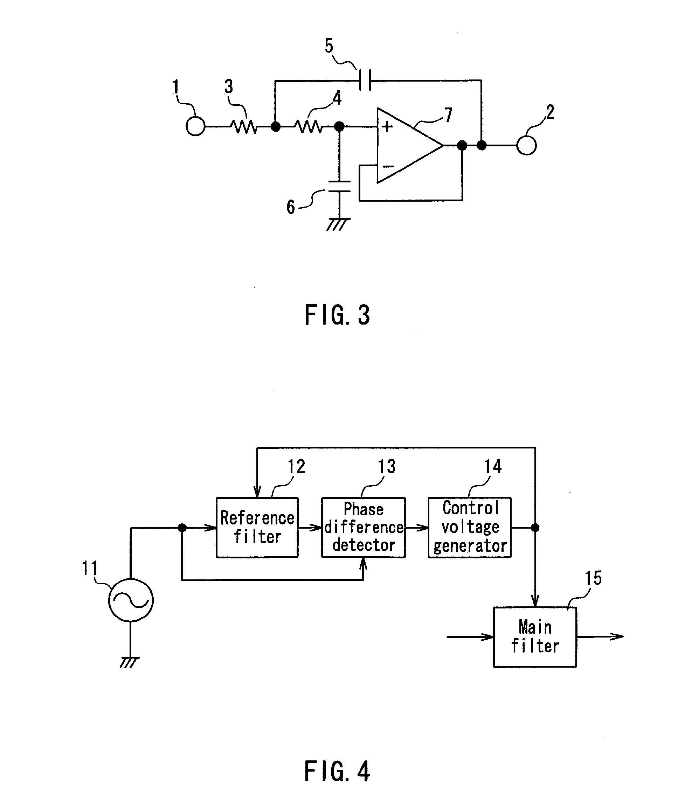

FIG. 3 is a circuit diagram showing an example of a basic configuration of a filter circuit that is used in a filter device. In FIG. 3, reference characters 1 and 2 denote a signal input terminal and a signal output terminal, respectively. Further, reference characters 3 and 4 denote a first resistance having a resistance value R and a second resistance having the same resistance value R as that of the first resistance 3, respectively. Reference characters 5, 6 and 7 denote a first capacitor having a capacity value C1, a second capacitor having a capacity value C2, and an OP amplifier for constituting an active filter, respectively.

With respect to a filter circuit having the above-described configuration, a method of correcting variations will be described in the following.

In the example of the basic configuration of a filter shown in FIG. 3, a cut-off frequency fc of this filter based on a transfer function between the signal input terminal 1 and the signal output terminal 2 is expressed by Expression (1) as follows.

$$fc = 1/(2\pi \times (R \times C1)^{\frac{1}{2}} \times (R \times C2)^{\frac{1}{2}})$$

$$= 1/(2\pi \times R \times (C1 \times C2)^{\frac{1}{2}}) \tag{1}$$

Where when values of a resistance and a capacitor that constitute the filter vary, variations in the CR product of these values are defined as v, and a cut-off frequency obtained in this case is defined as fcv, the cut-off frequency fcv is expressed by Expression (2) as follows.

$$fcv = 1/(2\pi \times (v \times R \times C1)^{\frac{1}{2}} \times (v \times R \times C2)^{\frac{1}{2}})$$

$$= 1/(2\pi \times v \times R \times (C1 \times C2)^{\frac{1}{2}}) \tag{2}$$

In the case where the CR product varies between, for example, -30% and +30% (v = 0.7 to 1.3), it follows that the cut-off frequency fcv varies between +43% and -23%.

Herein, it is assumed that the resistance value R of the first resistance 3 and the second resistance 4 can be changed in some way to a value that is an inverse multiple of a value of the variations (1 / v times). For example, when there are variations of +30% (v =1.3), the resistance value R is multiplied by 1/1.3 = 0.769. As a result, an apparent product of resistance values and capacity values satisfies Expression (1), giving the cut-off frequency fc, thereby allowing a desired value to be obtained.

In the above-described manner, variations of a filter device installed in a semiconductor apparatus can be corrected.

The description is directed next to a conventional filter device whose variations can be corrected.

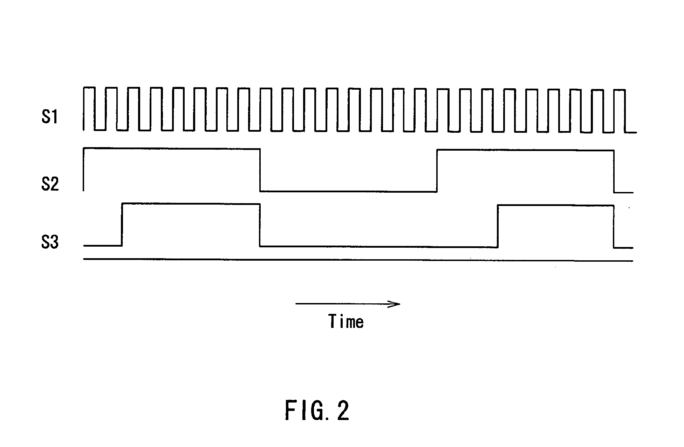

FIG. 4 is a circuit block diagram showing an example of a configuration of a conventional filter device. In FIG. 4, reference characters 11 and 12 denote a reference signal generating source and a reference filter, respectively. Further, reference character 13 denotes a phase difference detector that is formed of a multiplier circuit. Reference characters 14 and 15 denote a control voltage generator and a main filter that performs fundamental signal processing, respectively Among these constituent elements, the reference filter 12 and the main filter 15 are formed of the above-described filter circuit, and the resistance value R of the first resistance 3 and the second resistance 4 that are shown in FIG. 2 can be changed using a control voltage outputted from the control voltage generator 14. As a method of changing the resistance value, for example, the resistances are formed of a MOS transistor, and a conductance of the MOS transistor is changed.

The description is directed next to the operation of a filter device with the above-described configuration.

Where a reference signal vs(t) generated by the reference signal generating source 11 has a frequency fs, the reference signal vs(t) can be expressed by Expression (3) as follows.

$$vs(t) = A \times \cos(2\pi \times fs \times t) \qquad (3)$$

In Expression (3) above, A and t denote an amplitude of vs(t) and a time, respectively.

An output signal vLPF(t) obtained by inputting the reference signal vs(t) to the reference filter 12 is expressed by Expression (4) as follows.

$$vLPF(t) = B \times \cos(2\pi \times fs \times t + \theta) \qquad (4)$$

In Expression (4) above, B and $\theta$ denote an amplitude of vLPF(t) and a phase difference caused by the reference filter 12, respectively.

In the case where the resistance value R of the first resistance 3 and the second resistance 4, the capacity value C1 of the first capacitor 5 and the capacity value C2 of the second capacitor 6 are set so that a cut-off frequency of the reference filter 12 equals the frequency fs of the reference signal vs(t), the phase difference $\theta$ has a value of -90 degrees when there are no variations and a value of -110.6 degrees when there are variations of +30%.

When the reference signal vs(t) and the output signal vLPF(t) of the reference filter 12 are inputted to the phase difference detector 13, an output signal vPD(t) obtained by multiplying these input signals is expressed as follows.

$$vPD(t) = vs(t) \times vLPF(t)$$
$$= A \times B \times (\cos\theta + \cos(4\pi \times fs \times t + \theta))/2 \qquad \dots (5)$$

In the output signal vPD (t), $\cos\theta$ is a direct current component corresponding to the phase difference $\theta$ and does not depend on the time t. The output signal vPD(t) is inputted to the control voltage generator 14, so that a control voltage is outputted from the control voltage generator 14 so as to obtain a resistance value that can cancel variations of the reference filter 12 according to $\cos\theta$. By applying this control voltage to the reference filter 12, a feedback loop is established, and thus the variations are corrected, thereby allowing a cut-off frequency of the reference filter 12 always to be equal to the frequency fs of the reference signal vs(t).

By establishing a connection so that even a resistance value of the main filter 15 is changed using a control voltage generated by the control voltage generator 14, variations of the main filter 15 also can be corrected.

With the above-described configuration, a filter device that avoids variations, which unavoidably occur in the production process of semiconductor apparatuses, can be installed in a semiconductor apparatus (see, for example, JP 2002-76842 A, pages 4 to 7 and FIG. 1).

However, in the above-described conventional configuration, correcting variations requires that a feedback loop always be established, and thus constituent elements irrelevant to a fundamental signal processing system such as a reference filter, a phase difference detector and a control voltage generator have to be operated all the time. Because of this, reduction in the current consumption of a filter device hardly can be achieved, which has been disadvantageous.

DISCLOSURE OF THE INVENTION

With the foregoing in mind, it is an object of the present invention to provide a filter device that easily can achieve reduction in current consumption and whose variations can be corrected.

In order to achieve the above-described object, a filter device according to the present invention includes as well as a main filter, a reference filter and a phase difference detecting circuit as in the conventional configuration, and a register that holds a control signal corresponding to a phase difference generated in the reference filter due to variations.

With this configuration, in order to correct variations, it is no longer required that the reference filter and the phase difference detecting circuit be operated all the time. Thus, in a filter device, reduction in current consumption easily can be achieved.

BRIEF DESCRIPTION OF THE DRAWINGS

FIG. 1 is a circuit block diagram showing an example of a configuration of a filter device according to an embodiment of the present invention.

FIG. 2 is a diagram showing a timing relationship between an output signal vPD(t) of a phase difference detector shown in FIG. 1 and a reference signal vref(t).

FIG. 3 is a circuit diagram showing a basic configuration of a second-order filter circuit used in a conventional filter device whose variations can be corrected.

FIG. 4 is a circuit block diagram showing an example of a configuration of the conventional filter device whose variations can be corrected.

BEST MODE FOR CARRYING OUT THE INVENTION

Hereinafter, a preferred embodiment of the present invention will be described by referring to the appended drawings.

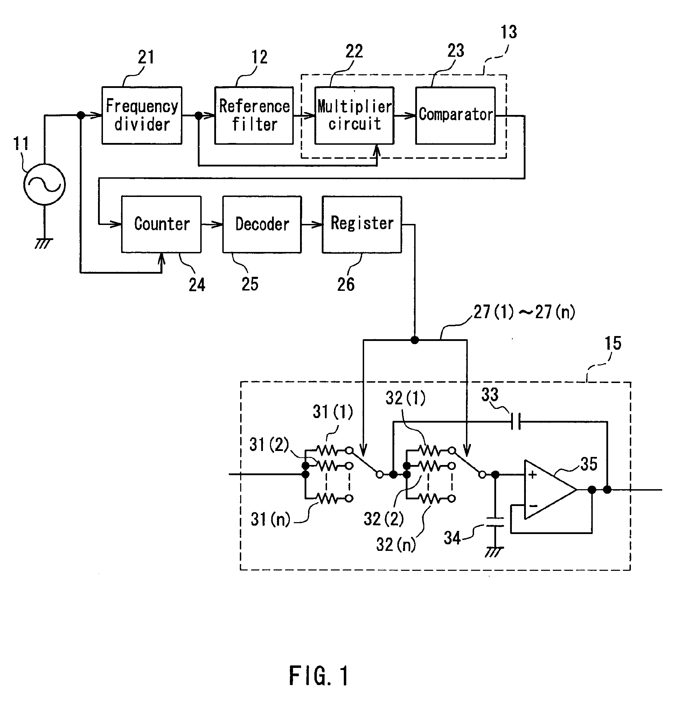

FIG. 1 is a circuit block diagram showing an example of a configuration of a filter device according to an embodiment of the present invention.

In FIG. 1, reference characters 11 and 21 denote a reference signal generating source and a frequency divider, respectively. Further, reference character 12 denotes a reference filter that is formed of a second-order filter such as shown in FIG. 3. Reference character 13 denotes a phase difference detector that is composed of a multiplier circuit 22 and a comparator 23. Reference characters 24, 25 and 26 denote a counter, decoder that generates a control signal, and a register, respectively. Reference characters 27(1), 27(2), ..., and 27(n) denote control signal lines. Reference character 15 denotes a main filter that is composed of n-first resistances 31(1), 31(2), ..., and 31(n) that have resistance values R(1), R(2), ..., and R(n), respectively, n-second resistances 32(1), 32(2), ..., and 32(n) that have the same resistance values as those of the first resistances 31(1), 31(2), ..., and 31(n), respectively, a first capacitor 33 having a capacity value C1, a second capacitor 34 having a capacity value C2, and an OP amplifier 35 for constituting an active filter.

A selection is made among the first resistances 31(1), 31(2), ..., and 31(n) and among the second resistances 32(1), 32(2), ..., and 32(n) by being activated by a control signal of a corresponding one of the control signal lines 27. In the following description, the n-first resistances 31(1), 31(2), ..., and 31(n) are referred to collectively also as first resistances 31, and the n-second resistances 32(1), 32(2), ..., and 32(n) are referred to collectively also as second resistances 32.

The description is directed next to an operation of the filter device according to this embodiment that has the above-described configuration.

A reference signal vref(t) generated by the reference signal generating source 11 is inputted to the frequency divider 21 having a frequency division ratio div, and based on an output of the frequency divider 21, a divided signal vs(t) is obtained When the divided signal vs(t) is inputted to the reference filter 12, in an output signal vLPF(t) of the reference filter 12, a phase difference θ with respect to the divided signal vs(t) is generated by the reference filter 12.

Similarly to the conventional case, in the case where the resistance values R of the first resistances 31 and the second resistances 32, the capacity value C1 of the first capacitor 33 and the capacity value C2 of the second capacitor 34 are set so that a cut-off frequency of the reference filter 12 equals a frequency fs of a reference signal vs (t), the phase difference θ has a value of -90 degrees when there are no variations and a value of -110.6 degrees when there are variations of +30%.

As in the conventional case, the output signal vLPF(t) of the reference filter 12 is inputted to the phase difference detector 13 and multiplied by the divided signal vs(t) in the multiplier circuit 22 thereby to obtain a signal vPD(t), though in this case, one of input signals is not a reference signal but a divided signal unlike the conventional case.

The output signal vPD(t) of the multiplier circuit 22 is inputted to the comparator 23 and compared with a predetermined reference level, and thus a rectangular wave signal VPD(t) is obtained as an output signal of the phase difference detector 13. The rectangular wave signal VPD(t) has a frequency double the frequency of the divided signal vs(t), and a duty ratio D of the rectangular wave signal VPD(t) varies according to the phase difference θ generated by the reference filter 12. Herein, the duty ratio D refers to a ratio of a segment of time in which the rectangular wave signal VPD(t) is at a high level to a period of the rectangular wave signal VPD(t). Using the phase difference 0, the duty ratio D can be expressed by Expression (6) as follows.

$$D=(180-\theta)/180 \tag{6}$$

For example, the duty ratio D has a value of 0.39 when there are variations of +30% in the reference filter 12 and a value of 0.5 when there are no variations in the reference filter 12.

The rectangular wave signal VPD(t) outputted from the phase difference detector 13 is inputted to the counter 24 and counted based on the reference signal vref(t) as a clock. FIG. 2 is a diagram showing a timing relationship between the rectangular wave signal VPD(t) that is inputted to the counter 24 and the reference signal vref(t) where the frequency division ratio div of the frequency divider 21 is 32. In FIG. 2, reference character S1 denotes the reference signal vref(t). Further, reference character S2 denotes the rectangular wave signal VPD(t) obtained when there are no variations in CR product, and reference character S3 denotes the rectangular wave signal VPD(t) obtained when there are variations in CR product of +30%.

The counter 24 counts the number of the reference signals vref(t) in a segment of time in which the rectangular wave signal VPD(t) is at a high level. In FIG. 2, a number Pcnt of counts is 8 when there are no variations and 6.17, or 6 with a fractional portion discarded, when there are variations of 30%. Using the frequency division ratio div, a relationship between the duty ratio D and the number Pcnt of counts can be expressed by Expression (7) as follows.

$$Pcnt=div\times D/2 \tag{7}$$

Therefore, based on Expressions (6) and (7) above, a relationship between the phase difference $\theta$ generated by the reference filter 12 and the number Pcnt of counts is expressed by Expression (8) as follows.

$$Pcnt=div\times(180-\theta)/360 \tag{8}$$

However, with respect to each value given by Expressions (7) and (8), digits to the right of a decimal point of the value are discarded. When there are variations of -30% to +30%, where the frequency division ratio div of the frequency divider 21 is 32, the number Pcnt of counts given by Expression (8) has a value among five values between 6 to 10 according to an amount of variations in CR product. The number Pent of counts is inputted to the decoder 25, and a control signal corresponding to the number Pcnt of counts is outputted and held in the register 26.

In this case, the control signal held by the register 26 activates any one of the five control signal lines 27(1), 27(2), ..., and 27(5) according to an amount of variations thereby to select a corresponding one of the first resistances 31(1), 31(2), ..., and 31(5) and a corresponding one of the second resistances 32(1), 32(2), ..., and 32(5).

The main filter 15 can have a cut-off frequency that is determined by these selected ones of the first resistances 31 and the second resistances 32, the first capacitor 33 and the second capacitor 34.

For example, it is assumed that when there are variations of +30%, the number Pcnt of counts by the counter 24 is 6, and the first resistance 31(1) and the second resistance 32(1) that have the resistance value R(1) are selected by the control signal line 27(1) in this case. The resistance value R(1) is corrected so as to be 0.816 times a value as the resistance value R that allows the filter to have a desired cut-off frequency when there are no variations in CR product, and thus an apparent amount of variations of +6.1% is obtained. In this case, a cut-off frequency of -5.7% with respect to the desired value is obtained, and thus a substantial improvement can be achieved with respect to the case of not performing correction, which results in an amount of variations of -23% from the desired cut-off frequency.

Table 1 shows examples of the phase difference $\theta$ of the reference filter 12 with respect to an amount of variations in CR product, the number Pcnt of counts by the counter 24, a resistance correction value, and an apparent amount of variations in CR product after correction. However, in Table 1, consideration is given only to variations in product of a resistance value and a capacity value and not to other factors, i.e. amounts of variations and errors in terms of, for example, variations in temperature properties of elements constituting the filter, variations in detection accuracy of the phase difference detector 13, the accuracy of the counts by the counter 24 and the like.

Table 1

| Variations in CR product (%) | | Phase difference θ (degree) | | Number Pcnt of counts | Resistance correction value | Apparent variations in CR product by correction (%) | |
|---|---|---|---|---|---|---|---|
| 30 | 15.1 | -110.6 | -101.3 | 6 | 0.816 | 6.1 | -6.1 |
| 15 | 0.1 | -101.2 | -90.1 | 7 | 0.930 | 6.9 | -6.9 |
| 0 | -13 | -90.0 | -78.8 | 8 | 1.070 | 7.0 | -7.0 |
| -13.1 | -25 | -78.7 | -67.6 | 9 | 1.235 | 7.4 | -7.4 |
| -25 | -30 | -67.5 | -62.7 | 10 | 1.380 | 3.4 | -3.4 |

As described above, according to this embodiment, a control signal for correcting variations that can be obtained as a result of detecting a phase difference of a reference filter is held in a resistor, and thus once variations are detected, the reference filter and a phase difference detector that are used for detection of variations become no longer necessary and their operations can be halted.

This embodiment described as an example the reference filter and the main filter that basically had a circuit configuration of the second-order filter shown in FIG. 3. However, the present invention is not limited thereto, and a filter with any circuit configuration can be used as long as a reference filter is formed of a second-order filter, a main filter is formed of a filter of an arbitrary order, and a resistance and a capacitor that are installed in a semiconductor apparatus are used.

Furthermore, this embodiment described as an example the case where a resistance value was corrected. However, the present invention is not limited thereto, and it also is possible to correct a capacity value of a capacitor. Further, a resistance value and a capacity value also can be corrected so as to obtain a corrected product of these values.

Moreover, a phase difference detector with any circuit configuration can be used as long as the phase difference detector outputs a rectangular wave signal that has a duty ratio according to a phase difference generated by a reference filter.

As described in the foregoing discussion, the present invention provides a particular effect that an excellent filter device can be provided in which a value of a control signal for selecting a cut-off frequency of a main filter is held in a register, and thus operations of a reference filter and a phase difference detector can be halted, thereby easily achieving reduction in current consumption, and whose variations can be corrected.

**Claims**

1. A filter device, comprising:

   a reference signal generating source that generates a reference signal;
   a frequency divider that divides the reference signal so as to output a divided signal;
   a reference filter that receives the divided signal as an input signal;
   a phase difference detector that receives an output signal of the reference filter and the divided signal from the frequency divider as input signals and outputs a signal having a duty ratio corresponding to a phase difference generated by the reference filter;
   a counter that receives the signal outputted by the phase difference detector and the reference signal as input signals and counts the duty ratio corresponding to the phase difference generated by the reference filter;
   a decoder that decodes a control signal for correcting variations based on an output signal of the counter;
   a register that holds the control signal outputted from the decoder and outputs the control signal; and
   a main filter that performs signal processing of selecting a cut-off frequency according to the control signal outputted from the register.

FIG. 1

FIG. 2

FIG. 3

FIG. 4

## INTERNATIONAL SEARCH REPORT

| | International application No. |
|---|---|
| | PCT/JP03/14561 |

### A. CLASSIFICATION OF SUBJECT MATTER
Int.Cl$^7$ H03H11/04

According to International Patent Classification (IPC) or to both national classification and IPC

### B. FIELDS SEARCHED

Minimum documentation searched (classification system followed by classification symbols)
Int.Cl$^7$ H03H11/04, H03H11/12

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 8-191231 A (Sony Corp.),<br>23 July, 1996 (23.07.96),<br>Par. Nos. [0044] to [0072]; Figs. 1 to 4<br>& GB 2296835 A      & TW 281829 A<br>& US 5942935 A | 1 |
| Y | JP 8-204504 A (Asahi Kasei Microsystems Co.,<br>Ltd.),<br>09 August, 1996 (09.08.96),<br>Par. Nos. [0024] to [0047]; Figs. 1 to 7<br>(Family: none) | 1 |
| Y | JP 2001-203574 A (NEC IC Miconsystem Kabushiki<br>Kaisha),<br>27 July, 2001 (27.07.01),<br>Par. Nos. [0021] to [0062]; Figs. 1 to 5<br>(Family: none) | 1 |

| | | | | |
|---|---|---|---|---|
| ☒ | Further documents are listed in the continuation of Box C. | ☐ | See patent family annex. | |

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 19 March, 2004 (19.03.04) | 06 April, 2004 (06.04.04) |

| Name and mailing address of the ISA/<br>Japanese Patent Office | Authorized officer |
|---|---|
| Facsimile No. | Telephone No. |

Form PCT/ISA/210 (second sheet) (July 1998)

**INTERNATIONAL SEARCH REPORT**

| International application No. |
| --- |
| PCT/JP03/14561 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 3-65812 A  (Toshiba Corp.), 20 March, 1991 (20.03.91), Full text; Figs. 1, 2 (Family: none) | 1 |
| A | JP 7-86873 A  (Toshiba Corp.), 31 March, 1995 (31.03.95), Full text; all drawings & EP 0626795 A2 | 1 |
| A | JP 5-347537 A  (NEC Corp.), 27 December, 1993 (27.12.93), Full text; all drawings & US 5416438 A | 1 |
| A | JP 11-177379 A  (NEC Corp.), 02 July, 1999 (02.07.99), Full text; all drawings & US 6366161 A | 1 |
| A | JP 2002-94357 A  (Matsushita Electric Industrial Co., Ltd.), 29 March, 2002 (29.03.02), Full text; all drawings & EP 1172933 A2          & CN 1333597 A & US 2002/0011896 A1 | 1 |
| A | JP 10-303699 A  (Asahi Kasei Microsystems Co., Ltd.), 13 November, 1998 (13.11.98), Full text; all drawings (Family: none) | 1 |

Form PCT/ISA/210 (continuation of second sheet) (July 1998)